# EUROPÄISCHE PATENTSCHRIFT

(11) **EP 3 026 586 B1**
(45) Veröffentlichungstag und Bekanntmachung des Hinweises auf die Patenterteilung: **10.04.2019**
(21) Anmeldenummer: 15192667.2
(22) Anmeldetag: 03.11.2015
(51) Int. Cl.: G06F 17/50

(54) **SIMULIERUNG VON TEMPERATURVERTEILUNGEN INNERHALB VON PFANNEN EINES HÜTTENWERKS UND INNERHALB VON IN DEN PFANNEN ENTHALTENER METALLSCHMELZE**
SIMULATION OF THE TEMPERATURE DISTRIBUTIONS WITHIN THE LADLES OF A SMELTERY AND METAL MELT CONTAINED WITHIN THE LADLES
SIMULATION DE REPARTITIONS DE TEMPERATURE DANS DES COULÉES D'USINE SIDERURGIQUES ET DANS UN METAL EN FUSION CONTENU DANS LES COULÉES

(30) Priorität: 28.11.2014 DE 102014224334
(43) Veröffentlichungstag der Anmeldung: 01.06.2016
(73) Patentinhaber: SMS group GmbH, 40237 Düsseldorf (DE)
(72) Erfinder: Odenthal, Hans-Jürgen, 40822 Mettmann (DE); Plociennik, Uwe, 40882 Ratingen (DE); Hönig, Michael, 41516 Grevenbroich (DE)
(74) Vertreter: Klüppel, Walter

(56) Entgegenhaltungen:
- WO-A2-02/36292
- WO-A2-2011/089621
- CN-A- 103 382 515
- LEE ET AL: "Modeling of in-ladle direct thermal control rheocasting process", MATERIALS SCIENCE AND ENGINEERING A: STRUCTURAL MATERIALS: PROPERTIES, MICROSTRUCTURES AND PROCESSING, ELSEVIER BV, NL, Bd. 449-451, 19. März 2007 (2007-03-19), Seiten 680-683, XP005914713, ISSN: 0921-5093, DOI: 10.1016/J.MSEA.2006.02.423
- Anonymous: "An overview of ESTER", , 15. Dezember 2010 (2010-12-15), XP055265845, Gefunden im Internet: URL:http://web.archive.org/web/20101215152 315/http://www.cham.co.uk/phoenics/d_polis /d_info/ester.htm [gefunden am 2016-04-15]

## Beschreibung

Die Erfindung betrifft ein Verfahren zum Steuern und/oder Regeln einzelner Prozessschritte, insbesondere Pfannenprozessschritte, in einem Hüttenwerk.

Des Weiteren betrifft die Erfindung ein Computerprogramm mit auf einem computerlesbaren Datenträger gespeicherten Programmcodemitteln.

Ferner betrifft die Erfindung einen Datenträger sowie ein Computersystem.

Es sind analytische Modelle zur Simulation von Temperaturverteilungen innerhalb von Pfannen eines Hüttenwerks und innerhalb von in den Pfannen enthaltener Metallschmelze bekannt. Mit den analytischen Modellen kann eine solche Simulation simultan zu einem Betrieb im Hüttenwerk erfolgen.

Des Weiteren sind numerische Modelle zur Simulation von Temperaturverteilungen innerhalb von Pfannen eines Hüttenwerks und innerhalb von in den Pfannen enthaltener Metallschmelze bekannt, welche eine numerische Strömungssimulation von Strömungen innerhalb der Metallschmelze umfassen. Diese numerischen Modelle bedürfen einer enormen Rechenleistung, weshalb sie nicht in Echtzeit zu einem Betrieb im Hüttenwerk genutzt werden können.

WO 02/36292 A2 beschreibt ein Verfahren und eine Vorrichtung zur Kontrolle der Stahltemperatur vom Gießspiegel einer Stranggießanlage bis zum Ofenabstich, wobei die Stahltemperatur des Gießspiegels "online" kontrolliert wird, also simultan zum Betrieb der Stranggießanlage.

CN103382515 A beschreibt ein Verfahren zum Überwachen der Temperatur des geschmolzenen Stahls im RH-Verfahren in Echtzeit. Das System umfasst die Berechnung der Temperatur des geschmolzenen Stahls unter Berücksichtigung der Wärmeableitung durch die Stahlpfannenauskleidung und die Vakuumkammerauskleidung, sowie die Korrektur der berechneter Werte basierend auf gemessenen Temperaturen, wobei die Temperatur der Stahlschmelze mittels eines Finite-Volumen-Verfahrens behandelt wird.

Aufgabe der Erfindung ist es, eine neuartige Simulation von Temperaturverteilungen innerhalb von Pfannen eines Hüttenwerks und innerhalb von in den Pfannen enthaltener Metallschmelze bereitzustellen, welche genaue Vorhersagen zu diesen Temperaturverteilungen in Echtzeit ermöglicht.

Diese Aufgabe wird durch ein Computerprogramm gemäß Anspruch 1, einen Datenträger gemäß Anspruch 8 und ein Computersystem gemäß Anspruch 9 gelöst. Vorteilhafte Ausgestaltungen sind in den abhängigen Ansprüchen wiedergegeben, welche jeweils für sich genommen oder in verschiedener Kombination miteinander einen Aspekt der Erfindung darstellen können.

Im Rahmen von Anspruch 1 wird ein Verfahren zum Steuern und/oder Regeln einzelner Pfannenprozessschritte, in einem Hüttenwerk, beschrieben wobei für jede Pfanne des Hüttenwerks und eine darin enthaltene Metallschmelze eine jeweils Temperaturverteilung unter Verwendung eines Finite-Volumen-Verfahrens und vorgegebener Randbedingungen numerisch simuliert wird, wozu die jeweilige Pfanne, die darin enthaltene Metallschmelze und eine die Pfanne umgebende Umgebung vorgegebener Größe zumindest teilweise in eine endliche Anzahl von Gitterzellen zerlegt werden, wobei die Simulationen über Randbedingungen miteinander kombiniert werden, und wobei aus den Simulationen Vorgaben zum Steuern und/oder Regeln der einzelnen Prozessschritte abgeleitet werden.

Durch die erfindungsgemäße Verwendung eines Finite-Volumen-Verfahrens und vorgegebener Randbedingungen sowie der damit verbundenen zumindest teilweisen Zerlegung der jeweiligen Pfanne, der darin enthaltenen Metallschmelze und der die Pfanne umgebenden Umgebung vorgegebener Größe in eine endliche Anzahl von Gitterzellen ist der zur Durchführung des erfindungsgemäßen Verfahrens erforderliche Rechenaufwand deutlich gegenüber herkömmlichen numerischen Modellen reduziert, was insbesondere eine numerische Simulation von instationären Temperaturverteilungen innerhalb von Pfannen eines Hüttenwerks und innerhalb von in den Pfannen enthaltener Metallschmelze in Echtzeit zu einem Betrieb im Hüttenwerk möglich macht. So ist es möglich, eine Vielzahl an Pfannen und deren Inhalt gleichzeitig zu simulieren.

Mittels des von der Erfindung verwendeten Verfahrens und der damit durchführbaren numerischen Simulation von instationären Temperaturverteilungen innerhalb von Pfannen eines Hüttenwerks und innerhalb von in den Pfannen enthaltener Metallschmelze können unter Berücksichtigung verschiedener Randbedingungen unterschiedliche Szenarien in Echtzeit numerisch simuliert werden. Auch lassen sich zukünftige Temperaturverläufe numerisch simulieren, wodurch genaue Vorhersagen zu instationären Temperaturverteilungen innerhalb von Pfannen des Hüttenwerks und innerhalb von in den Pfannen enthaltener Metallschmelze ermöglicht werden. Unter Berücksichtigung von entsprechend vorhersagbaren instationären Temperaturverteilungen können Prozessabläufe geplant und optimiert werden, was wiederum die Prozesssicherheit und die Betriebssicherheit erhöht.

Bei der Durchführung des von der Erfindung verwendeten Verfahrens können Konvektionsströmungen innerhalb einer in einer Pfanne enthaltenen Metallschmelze numerisch simuliert und vorausberechnet werden, wozu die numerische Strömungsmechanik (Computational Fluid Dynamics; CFD) verwendet wird. Diese Simulationsergebnisse werden einem Computerprogramm als Randbedingungen für die numerische Simulation zur Verfügung gestellt.

Nach dem von der Erfindung verwendeten Verfahren besteht die Möglichkeit, die instationären Temperaturverteilungen einer Pfanne und der darin enthaltenen Metallschmelze getrennt voneinander unter relativ geringer Rechenleistung numerisch zu simulieren und diese Simulationen über Randbedingungen, beispielsweise einem Wärmeübergang zwischen der Pfanne und der Metallschmelze, miteinander zu kombinieren. Auch kann die Pfanne einen Deckel, eine Außenwand und eine an der Innenseite der Außenwand angeordnete feuerfeste Innenauskleidung, beispielsweise eine Ausmauerung, aufweisen, deren instationäre Temperaturverteilungen ebenfalls separat numerisch simuliert werden, wobei diese Simulationen ebenfalls über Randbedingungen miteinander und den Simulationen der instationären Temperaturverteilung der in der Pfanne enthaltenen Metallschmelze kombiniert werden können. Insgesamt kann somit ein Mehrkörpermodell geschaffen werden, dessen Reaktion auf verschiedene Prozessschritte und Gegebenheiten numerisch simulierbar ist.

Ein Anwender der Erfindung kann verschiedene Prozessschritte zu einer Prozesskette miteinander kombinieren, wodurch Randbedingungen generiert werden, welche bei einer Durchführung des erfindungsgemäßen Verfahrens berücksichtigt werden.

Der zur Durchführung des von der Erfindung verwendeten Verfahrens erforderliche Rechenaufwand kann weitergehender dadurch reduziert werden, dass von rotationssymmetrisch ausgebildeten Pfannen ausgegangen wird, von denen jeweils zunächst ein zweidimensionales Modell nebst der darin enthaltenen Metallschmelze numerisch simuliert und aus diesem zweidimensionalen Modell über die Rotationssymmetrie und eine entsprechende Transformation ein dreidimensionales Modell der Pfanne und der darin enthaltenen Metallschmelze erzeugt wird. Nicht rotationssysmmetrische Pfannen können durch den Einsatz asymmetrischer Gitternetze ebenfalls berechnet werden.

Durch die gemäß der Erfindung mögliche Berechnung der instationären Temperaturverteilung bzw. der jeweiligen Temperatur der in einer Pfanne enthaltenen Metallschmelze im Voraus ist die Temperatur der Metallschmelze zu den Zeitpunkten "Pfanne auf", "Pfanne voll" und "Pfanne leer" bekannt. Hierdurch erhält ein Betreiber eines Hüttenwerks die Möglichkeit, eine Gießgeschwindigkeit entsprechend des gemäß der erfindungsgemäßen Simulation zu erwartenden Temperaturverlaufs der Metallschmelze zu optimieren.

Die Erfindung ermöglicht des Weiteren eine Vorhersage der minimalen und/oder maximalen Verweilzeit einer Pfanne im jeweiligen Prozessschritt, beispielsweise der Aufheizzeit der Pfanne. Zudem ist eine Vorhersage der Temperaturen für das Mehrkörpersystem Pfanne, mit Pfannendeckel und Ausmauerung, und Pfanneninhalt möglich. Auch ist eine Vorhersage des Verschleißes der Ausmauerung und dessen Berücksichtigung bei der thermischen Berechnung möglich. Es ist eine Vorhersage der Wartung der Ausmauerung einer Pfanne möglich. Des Weiteren ist eine Vorhersage der Heizleistung und Heizdauer zur Steuerung der Erwärmungsanlagen, beispielsweise eines Volumenstroms der Brenner beim Vorwärmen der Pfannen und deren Vorwärmdauer, möglich. Es können notwendige Informationen zur Steuerung der logistischen Abläufe, beispielsweise der Zeit bis zum Erreichen einer minimal zulässigen Temperatur des Pfanneninhalts, bereitgestellt werden. Hierdurch kann die maximal zulässige Zeit zur Bereitstellung der nächsten Pfanne festgelegt werden. Im Störfall können mit den erfindungsgemäß gewonnenen Informationen aus Offline-Simulationen und dem Ist-Zustand der aktuellen Pfannen Ersatzstrategien für das weitere Vorgehen simuliert und bewertet werden. Die Erfindung kann online zur Echtzeit-Simulation, offline zur Planung der Prozessschritte und/oder zur Wiederholung zur Simulation erfasster Prozessdaten durchgeführter Prozesse verwendet werden.

Aus der von der Erfindung verwendeten Simulation werden Vorgaben zur Steuerung und/oder Regelung einzelner Prozessschritte abgeleitet. Beispielsweise kann auf Basis der Simulation eine Aufheizzeit, eine Heizleistung, eine Spüldauer, eine Zugabe von Kühlschrott oder dergleichen zur Steuerung der Temperatur in der Pfanne bzw. Metallschmelze vorgegeben werden. Insbesondere können die vom Modell ermittelten Werte für die thermische Energie, die Aufheizzeit, die Abkühlzeit, die Spüldauer, die Legierungszugabe und dergleichen zur Steuerung und/oder Regelung einzelner Pfannenprozessschritte bzw. des Pfanneneinsatzes im Hüttenwerk verwendet werden.

Gemäß einer vorteilhaften Ausgestaltung werden eine Temperatur an jeder Pfanne und/oder der darin enthaltenen Metallschmelze sowie eine Position der Pfanne in zeitlichen Abständen oder kontinuierlich gemessen, wobei die gemessene Temperatur mit der für die Pfanne bzw. für die darin enthaltene Metallschmelze simulierten Temperaturverteilung verglichen wird, wobei bei einer Abweichung der Temperaturverteilung von der gemessenen Temperatur um ein vorgegebenes Ausmaß wenigstens eine Randbedingung zur Anpassung der Temperaturverteilung an die gemessene Temperatur korrigiert wird. Hierdurch kann die durchgeführte numerische Simulation simultan zu deren Durchführung auf ihre Richtigkeit überprüft und gegebenenfalls angepasst bzw. optimiert werden. Mit den Messungen lassen sich Randbedingungen generieren und gegebene Randbedingungen an tatsächliche Gegebenheiten anpassen. Zudem können die Messungen zur Prüfung und Überwachung der Pfannen und ihrer Inhalte verwendet werden.

Nach einer weiteren vorteilhaften Ausgestaltung wird durch individuelle Randbedingungen ein Wärmeübergang zwischen einer Pfanne und der darin enthaltenen Metallschmelze, ein Verschleiß einer feuerfesten Innenauskleidung der Pfanne, eine erforderliche Vorwärmung der Pfanne und/oder eine vorliegende Abkühlung der Pfanne bei der numerischen Simulation berücksichtigt. Dies kann über Ergebnisse von Messungen der jeweiligen Temperatur einer Pfanne und der darin enthaltenen Metallschmelze erfolgen. Die Messungen der jeweiligen Temperatur der in einer Pfanne enthaltenen Metallschmelze können auch zur Adaption des Wärmeübergangs zwischen der Metallschmelze und der Pfanne bzw. zugehöriger Randbedingungen verwendet werden. Des Weiteren ist es durch Messungen der Temperatur der Pfannenoberfläche möglich, den Verschleiß einer feuerfesten Innenauskleidung, insbesondere einer Ausmauerung, bzw. zugehörige Randbedingungen zu ermitteln. Das jeweilig ermittelte Verschleißprofil der feuerfesten Innenauskleidung kann als Randbedingung bei der erfindungsgemäßen numerischen Simulation berücksichtigt werden, wodurch eine Durchbruchgefahr der Pfanne reduziert werden kann. Auch eine hierdurch mögliche Vorausberechnung einer Verschleißrate der feuerfesten Innenauskleidung einer Pfanne kann bei der Durchführung des erfindungsgemäßen Verfahrens als Randbedingung berücksichtigt werden. Weitere individuelle Randbedingungen können beispielsweise die Abmessungen einer Pfanne, die Abmessungen und das Material einer feuerfesten Innenauskleidung einer Pfanne, das Gewicht einer Pfanne, das Füllgewicht einer Pfanne oder dergleichen sein.

Eine weitere vorteilhafte Ausgestaltung sieht vor, dass prozessschrittspezifische Randbedingungen mit einer zeitlichen Vorgabe berücksichtigt werden. Alle Prozessschritte einer in einem Hüttenwerk auszuführenden Prozesskette können gemäß dem erfindungsgemäßen Verfahren zeitgetreu numerisch simuliert werden, was durch zeitliche Vorgabe der Randbedingungen zur Beschreibung des jeweiligen Prozessschritts erfolgt. Eine Prozesskette kann beispielsweise die Schritte Erwärmen einer Pfanne, Einfüllen der Metallschmelze in die erwärmte Pfanne, Behandeln (z. B. durch chemische Reaktionen) der in der Pfanne enthaltenen Metallschmelze, Abdecken der Pfanne mit ihrem oder einem separaten Deckel, Ausleeren der Metallschmelze aus der Pfanne in einen Zwischenbehälter des Hüttenwerks, Ausleeren von Schlacke aus der Pfanne und Abkühlen der Pfanne umfassen. Weitere prozessschrittspezifische Randbedingungen können beispielsweise aus einer Gasanalyse, einem Gasvolumenstrom, einem Heizwert oder dergleichen abgeleitet werden.

Es wird des Weiteren als vorteilhaft erachtet, wenn die Temperaturverteilungen der Pfannen und der darin jeweilig enthaltenen Metallschmelze simultan zu einem Betrieb im Hüttenwerk numerisch simuliert werden. Eine solche numerische Online-Simulation der instationären Temperaturverteilungen innerhalb von Pfannen eines Hüttenwerks und innerhalb von in den Pfannen enthaltener Metallschmelze ist herkömmlich nicht möglich, da herkömmliche numerische Simulationen einer hierzu zu großen Rechenleistung bedürfen. Der numerischen Online-Simulation können zeitlich erfasste Positionen der Prozessrouten der Pfannen und Daten aus Temperaturmessungen zugeführt werden. Diese Positionen und Daten können zusätzlich gespeichert werden, um für eine nachträgliche numerische Offline-Simulation zur Verfügung zu stehen.

Vorteilhafterweise werden die Temperaturverteilungen der Pfannen und der darin jeweilig enthaltenen Metallschmelze unabhängig von einem Betrieb im Hüttenwerk numerisch simuliert. Eine solche numerische Offline-Simulation kann sich von einer Online-Simulation allein durch die Art der Versorgung dieser Simulationen mit Daten unterscheiden. Einer numerischen Offline-Simulation können Daten beispielsweise über Eingabedateien, gespeicherte Prozessdaten und/oder durch Eingabe per Hand zugeführt werden. Eine numerische Offline-Simulation kann auch zur Planung von Prozessketten innerhalb eines Hüttenwerks verwendet werden.

Ferner wird vorgeschlagen, dass die numerische Simulation auf Basis von Prozessdaten eines bereits erfolgten Betriebs im Hüttenwerk durchgeführt wird. Dies macht insbesondere eine historische Datenanalyse möglich, um Prozessabläufe weitergehender untersuchen und optimieren zu können.

Mit Anspruch 8 wird ein Datenträger mit einem vorgenannten Computerprogramm vorgeschlagen. Mit dem Datenträger sind die oben mit Bezug auf das Verfahren genannten Vorteile entsprechend verbunden.

Mit Anspruch 9 wird ein Computersystem vorgeschlagen, auf dem ein vorgenanntes Computerprogramm geladen ist. Mit dem Computersystem sind die oben mit Bezug auf das Verfahren genannten Vorteile entsprechend verbunden.

Im Folgenden wird die Erfindung unter Bezugnahme auf die anliegenden Figuren anhand von bevorzugten Ausführungsbeispielen exemplarisch erläutert, wobei die nachfolgend dargestellten Merkmale sowohl jeweils für sich genommen als auch in verschiedener Kombination miteinander einen Aspekt der Erfindung darstellen können. Es zeigen
- Figur 1:: eine schematische Darstellung einer Prozesskette innerhalb eines Hüttenwerks und
- Figur 2:: einen zeitlichen Verlauf von Randbedingungen für eine erfindungsgemäße numerische Simulation.

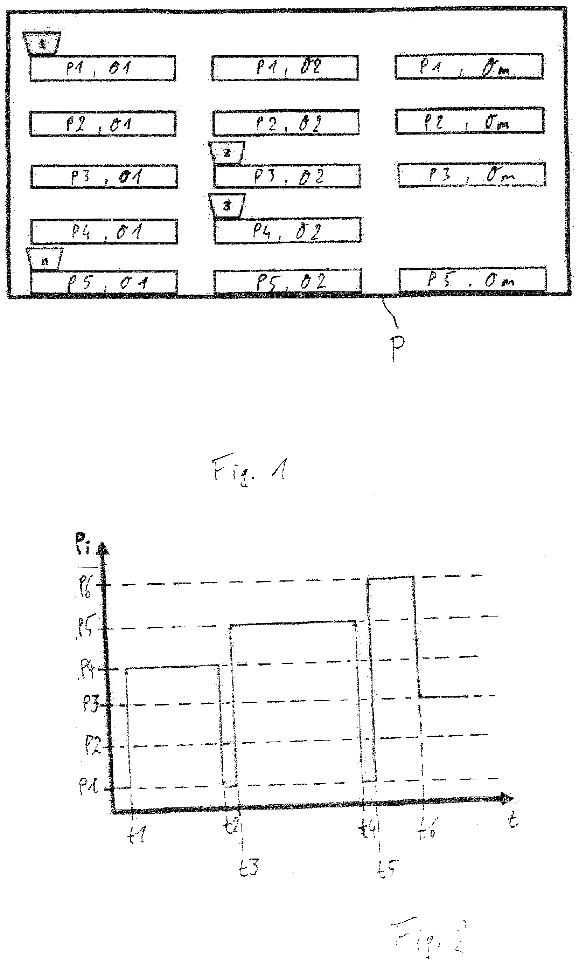

Figur 1 zeigt eine schematische Darstellung einer Prozesskette P innerhalb eines Hüttenwerks mit n Pfannen. Die Prozesskette P umfasst fünf verschiedene Prozessschritte P1 bis P5 und m Orte O1 bis Om, an denen jeweils wenigstens einer der Prozessschritte P1 bis P5 durchführbar ist. Eine Pfanne 1 befindet sich am Ort O1 zur Durchführung des Prozessschritts P1. Eine weitere Pfanne 2 befindet sich am Ort O2 zur Durchführung des Prozessschritts P3. Eine weitere Pfanne 3 befindet sich am Ort O2 zur Durchführung des Prozessschritts P4. Eine weitere Pfanne n befindet sich am Ort O1 zur Durchführung des Prozessschritts P5.

Figur 2 zeigt einen zeitlichen Verlauf von Randbedingungen für eine erfindungsgemäße numerische Simulation. Eine Pfanne eines Hüttenwerks kann beispielsweise zu Beginn in einem Prozessschritt P1 und unter Berücksichtigung von mit dem Prozessschritt P1 verbundenen Randbedingungen bis zum Zeitpunkt t1 aufgewärmt werden. Vom Zeitpunkt t1 bis t2 kann die Pfanne in einem Prozessschritt P4 und unter Berücksichtigung von mit dem Prozessschritt P4 verbundenen Randbedingungen mit einer Metallschmelze befüllt werden. Vom Zeitpunkt t2 bis t3 kann die befüllte Pfanne in dem Prozessschritt P1 und unter Berücksichtigung von mit dem Prozessschritt P1 verbundenen Randbedingungen aufgewärmt werden. Vom Zeitpunkt t3 bis t4 kann die in der Pfanne enthaltene Metallschmelze in einem Prozessschritt P5 und unter Berücksichtigung von mit dem Prozessschritt P5 verbundenen Randbedingungen behandelt werden. Vom Zeitpunkt t4 bis t5 kann die befüllte Pfanne in dem Prozessschritt P1 und unter Berücksichtigung von mit dem Prozessschritt P1 verbundenen Randbedingungen aufgewärmt werden. Vom Zeitpunkt t5 bis t6 kann die in der Pfanne enthaltene Metallschmelze in einem Prozessschritt P6 und unter Berücksichtigung von mit dem Prozessschritt P6 verbundenen Randbedingungen aus der Pfanne in einen Zwischenbehälter gegossen werden. Vom Zeitpunkt t6 an kann die in der Pfanne enthaltene Schlacke in einem Prozessschritt P3 und unter Berücksichtigung von mit dem Prozessschritt P3 verbundenen Randbedingungen aus der Pfanne gegossen werden.

### Bezugszeichenliste

- 1: Pfanne
- 2: Pfanne
- 3: Pfanne
- n: Pfanne
- P: Prozesskette
- P1: Prozessschritt
- P2: Prozessschritt
- P3: Prozessschritt
- P4: Prozessschritt
- P5: Prozessschritt
- O1: Ort
- O2: Ort
- Om: Ort

## Patentansprüche

1. Computerprogramm mit auf einem computerlesbaren Datenträger gespeicherten Programmcodemitteln, die, wenn sie auf einem Computer bzw. einer entsprechenden Recheneinheit ausgeführt werden, den Computer oder die entsprechende Recheneinheit veranlassen, ein Verfahren zum Steuern und/oder Regeln einzelner Pfannenprozessschritte in einem Hüttenwerk durchzuführen,
- in dem für jede Pfanne (1,..., n) des Hüttenwerks eine Temperaturverteilung der Pfanne (1,..., n) und eine Temperaturverteilung einer darin enthaltenen Metallschmelze unter Verwendung eines Finite-Volumen-Verfahrens und vorgegebener Randbedingungen numerisch simuliert werden, wozu die jeweilige Pfanne (1,..., n), die darin enthaltene Metallschmelze und eine die Pfanne (1,..., n) umgebende Umgebung vorgegebener Größe jeweils zumindest teilweise in eine endliche Anzahl von Gitterzellen zerlegt werden,
- wobei ein Erwärmen der Pfanne (1,..., n), ein Einfüllen der Metallschmelze in die erwärmte Pfanne (1,..., n), ein Behandeln der in der Pfanne (1,..., n) enthaltenen Metallschmelze, ein Abdecken der Pfanne (1,..., n) mit einem Deckel, ein Ausleeren der Metallschmelze aus der Pfanne (1,..., n) in einen Zwischenbehälter des Hüttenwerks, ein Ausleeren von Schlacke aus der Pfanne (1,..., n) und/oder ein Abkühlen der Pfanne (1,..., n) unter Berücksichtigung der simulierten Temperaturverteilungen gesteuert und/oder geregelt werden bzw. wird.

2. Computerprogramm nach Anspruch 1, **dadurch gekennzeichnet, dass** eine Temperatur an jeder Pfanne (1,..., n) und/oder der darin enthaltenen Metallschmelze sowie eine Position der Pfanne (1,..., n) in zeitlichen Abständen oder kontinuierlich gemessen wird, wobei die gemessene Temperatur mit der für die Pfanne (1,..., n) bzw. für die darin enthaltene Metallschmelze simulierten Temperaturverteilung verglichen wird, wobei bei einer Abweichung der Temperaturverteilung von der gemessenen Temperatur um ein vorgegebenes Ausmaß wenigstens eine Randbedingung zur Anpassung der Temperaturverteilung an die gemessene Temperatur korrigiert wird.

3. Computerprogramm nach Anspruch 1 oder 2, **dadurch gekennzeichnet, dass** durch individuelle Randbedingungen ein Wärmeübergang zwischen einer Pfanne (1,..., n) und der darin enthaltenen Metallschmelze, ein Verschleiß einer feuerfesten Innenauskleidung der Pfanne (1,..., n), eine erforderliche Vorwärmung der Pfanne (1,..., n) und/oder eine vorliegende Abkühlung der Pfanne (1,..., n) bei der numerischen Simulation berücksichtigt wird.

4. Computerprogramm nach einem der Ansprüche 1 bis 3, **dadurch gekennzeichnet, dass** prozessschrittspezifische Randbedingungen mit einer zeitlichen Vorgabe berücksichtigt werden.

5. Computerprogramm nach einem der Ansprüche 1 bis 4, **dadurch gekennzeichnet, dass** die Temperaturverteilungen der Pfannen (1,..., n) und der darin jeweilig enthaltenen Metallschmelze in Echtzeit zu einem Betrieb im Hüttenwerk simuliert werden.

6. Computerprogramm nach einem der Ansprüche 1 bis 4, **dadurch gekennzeichnet, dass** die Temperaturverteilungen der Pfannen (1,..., n) und der darin jeweilig enthaltenen Metallschmelze unabhängig von einem Betrieb im Hüttenwerk simuliert werden.

7. Computerprogramm nach Anspruch 6, **dadurch gekennzeichnet, dass** die numerische Simulation auf Basis von Prozessdaten eines bereits erfolgten Betriebs im Hüttenwerk durchgeführt wird.

8. Datenträger mit einem Computerprogramm nach einem der Ansprüche 1 bis 7.

9. Computersystem, auf dem ein Computerprogramm nach einem der Ansprüche 1 bis 7 geladen ist.

## Claims

1. Computer program with program code means which are stored on a computer-readable data carrier and which when executed on a computer or a corresponding computing unit cause the computer or the corresponding computing unit to perform a method for controlling and/or regulating individual ladle process steps in a steelworks,
- in which for each ladle (1 ... n) of the steelworks a temperature distribution of the ladle (1 ... n) and a temperature distribution of a metal melt present therein are numerically simulated with use of a finite-volume method and predetermined boundary conditions, for which purpose the respective ladle (1 ... n), the metal melt present therein and an environment of predetermined size surrounding the ladle (1 ... n) are each at least partly resolved into a finite number of grid cells,
- wherein heating of the ladle (1 ... n), pouring of the metal melt into the heated ladle (1 ... n), handling of the metal melt contained in the ladle (1 ... n), covering of the ladle (1 ... n) by a cover, emptying the metal melt from the ladle (1 ... n) into an intermediate container of the steelworks, emptying of slag from the ladle (1 ... n) and/or cooling of the ladle (1 ... n) is or are controlled and/or regulated with consideration of the simulated distributions.

2. Computer program according to claim 1, **characterised in that** a temperature at each ladle (1 ... n) and/or the metal melt present therein as well as a position of the ladle (1 ... n) are continuously measured at intervals in time, wherein the measured temperature is compared with the temperature distribution simulated for the ladle (1 ... n) or for the metal melt present therein, wherein in the case of a difference of the temperature distribution from the measured temperature by a predetermined amount at least one boundary condition for adaptation of the temperature distribution to the measured temperature is corrected.

3. Computer program according to claim 1 or 2, **characterised in that**, through individual boundary conditions, heat transfer between a ladle (1 ... n) and the metal melt present therein, wear of a refractory inner lining of the ladle (1 ... n), a required preheating of the ladle (1 ... n) and/or an existing cooling of the ladle (1 ... n) is taken into consideration in the numerical simulation.

4. Computer program according to any one of claims 1 to 3, **characterised in that** boundary conditions specific to process step are taken into consideration with a time default.

5. Computer program according to any one of claims 1 to 4, **characterised in that** the temperature distributions of the ladles (1 ... n) and the metal melt respectively contained therein are simulated in real time with respect to an operation in the steelworks.

6. Computer program according to any one of claims 1 to 4, **characterised in that** the temperature distributions of the ladles (1 ... n) and the metal melt respectively present therein are simulated independently of an operation in the steelworks.

7. Computer program according to claim 6, **characterised in that** the numerical simulation is carried out on the basis of process data of an operation in the steelworks that has already take place.

8. Data carrier with a computer program according to any one of claims 1 to 7.

9. Computer system onto which a computer program according to any one of claims 1 to 7 is loaded.

## Revendications

1. Programme informatique comprenant des moyens de codes de programmes enregistrés sur un support de données lisible par ordinateur, qui, lorsqu'ils sont exécutés sur un ordinateur, respectivement sur une unité de calcul correspondante, invitent l'ordinateur ou l'unité de calcul correspondante à mettre en oeuvre un procédé pour la commande et/ou le réglage d'étapes opératoires liées à des poches individuelles dans une usine sidérurgique ;
- dans lequel, pour chaque poche (1, ..., n) de l'usine sidérurgique, on simule par voie numérique une distribution de la température de la poche (1, ..., n) et une distribution de la température d'un métal fondu qui y est contenu en utilisant un procédé du type à volume fini ainsi que des conditions aux limites prédéfinies, ce pourquoi, la poche respective (1, ..., n), le métal fondu qui y est contenu et un environnement de dimension prédéfinie entourant la poche (1, ..., n) sont respectivement décomposés au moins en partie en un nombre fini de cellules de grilles ;
- dans lequel un réchauffement de la poche (1, ..., n), un remplissage de la poche réchauffée (1, ..., n) avec le métal fondu, un traitement du métal fondu contenu dans la poche (1,..., n), un recouvrement de la poche (1, ..., n) avec un couvercle, une élimination du métal fondu hors de la poche (1, ..., n) dans un récipient intermédiaire de l'usine sidérurgique, une élimination du laitier hors de la poche (1,..., n) et/ou un refroidissement de la poche (1, ..., n) sont, respectivement est commandé(s) et/ou réglé(s) en prenant en compte les distributions simulées de la température.

2. Programme informatique selon la revendication 1, **caractérisé en ce qu'**on mesure une température liée à chaque poche (1, ..., n) et/ou liée au métal fondu qui y est contenu, ainsi qu'une position de la poche (1, ..., n) à des intervalles de temps ou en continu ; dans lequel la température mesurée est comparée à la distribution de température simulée pour la poche (1, ..., n), respectivement pour le métal fondu qui y est contenu ; dans lequel, dans le cas d'une déviation de la distribution de température par rapport à la température mesurée d'une ampleur prédéfinie, on corrige au moins une condition aux limites dans le but d'adapter la distribution de température à la température mesurée.

3. Programme informatique selon la revendication 1 ou 2, **caractérisé en ce que**, via des conditions aux limites individuelles on prend en compte, lors de la simulation numérique, un transfert de chaleur entre une poche (1, ..., n) et le métal fondu qui y est contenu, une usure d'un revêtement interne réfractaire de la poche (1, ..., n), un préchauffage requis de la poche (1, ..., n) et/ou un refroidissement en vigueur de la poche (1, ..., n).

4. Programme informatique selon l'une quelconque des revendications 1 à 3, **caractérisé en ce que** des conditions aux limites spécifiques aux étapes opératoires sont prises en compte dans le cadre d'une prédétermination temporelle.

5. Programme informatique selon l'une quelconque des revendications 1 à 4, **caractérisé en ce que** les distributions de température des poches (1, ..., n) et du métal fondu qui y est respectivement contenu sont simulées en temps réel par rapport à une exploitation dans l'usine sidérurgique.

6. Programme informatique selon l'une quelconque des revendications 1 à 4, **caractérisé en ce que** les distributions de température des poches (1, ..., n) et du métal fondu qui y est respectivement contenu sont simulées indépendamment d'une exploitation dans l'usine sidérurgique.

7. Programme informatique selon la revendication 6, **caractérisé en ce que** la simulation numérique est mise en oeuvre sur base de données opératoires d'une exploitation déjà réalisée dans l'usine sidérurgique.

8. Support de données comprenant un programme informatique selon l'une quelconque des revendications 1 à 7.

9. Système informatique sur lequel est chargé un programme informatique selon l'une quelconque des revendications 1 à 7.
